(19) Europäisches Patentamt / European Patent Office / Office européen des brevets

(11) **EP 1 087 490 B1**

(12) **FASCICULE DE BREVET EUROPEEN**

(45) Date de publication et mention de la délivrance du brevet:
**19.01.2011 Bulletin 2011/03**

(51) Int Cl.:
**H02H 1/00** *(2006.01)* **H03M 1/12** *(2006.01)*

(21) Numéro de dépôt: **00410111.9**

(22) Date de dépôt: **06.09.2000**

(54) **Dispositif de protection électrique avec convertisseur analogique-numérique du type sigma-delta**

Elektrische Schutzschaltung mit Sigma-Delta-Analog-Digitalwandler

Electrical protection device with a sigma-delta analog-to-digital converter

(84) Etats contractants désignés:
**DE GB IT**

(30) Priorité: **27.09.1999 FR 9912256**

(43) Date de publication de la demande:
**28.03.2001 Bulletin 2001/13**

(73) Titulaire: **Schneider Electric Industries SAS**
**92500 Rueil-Malmaison (FR)**

(72) Inventeurs:
• **Allin, Patrice**
**38050 Grenoble Cedex 09 (FR)**

• **Barjonnet, Jean-Paul**
**38050 Grenoble Cedex 09 (FR)**
• **Suptitz, Eric**
**38050 Grenoble Cedex 09 (FR)**

(74) Mandataire: **Tripodi, Paul et al**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**US-A- 4 943 888    US-A- 5 627 536**

## Description

L'invention concerne un dispositif de protection électrique comportant une pluralité de capteurs, un multiplexeur connecté à la sortie des capteurs pour recevoir une pluralité de signaux électriques à mesurer avec une précision prédéterminée, un convertisseur analogique-numérique, connecté à la sortie du multiplexeur, et des moyens de traitement numérique connectés au convertisseur analogique-numérique.

Il est classique, dans les dispositifs de protection électrique, et plus particulièrement dans un déclencheur électronique d'un disjoncteur électrique, de multiplexer les courants et/ou les tensions d'un réseau électrique à protéger, puis d'effectuer une conversion analogique-numérique avant de les traiter dans un circuit de traitement numérique, de préférence à microprocesseur voir par exemple les documents US-A-5,101,316 et US-A-4,672,501.

Il a, par ailleurs été proposé d'utiliser dans un déclencheur électronique des convertisseurs analogique-numérique de type sigma-delta. Dans ce cas, le déclencheur comporte un convertisseur associé à chaque voie de mesure, c'est-à-dire à chaque capteur de courant. Dans le document US-A-4.943.888, trois convertisseurs sigma-delta sont nécessaires. Dans le cas d'un déclencheur haut de gamme il peut y avoir jusqu'à 8 voies de mesure, une pour les courants des trois phases, une pour le courant du neutre, trois pour les tensions des trois phases et une pour le courant homopolaire, ce qui impliquerait l'utilisation de 8 convertisseurs.

L'utilisation d'un multiplexeur en combinaison avec un convertisseur analogique-numérique de type sigma-delta n'a pas été envisagée jusqu'ici dans un dispositif de protection en raison des problèmes posés par les signaux transitoires pouvant être créés par un front brusque lors du passage d'une voie de mesure à la suivante.

L'invention a pour but d'améliorer la précision de mesure d'un dispositif de protection électrique plus particulièrement d'un déclencheur électronique avec un coût et un volume réduits.

Selon l'invention, ce but est atteint par le fait que le convertisseur analogique-numérique est du type sigma-delta, comportant un modulateur sigma-delta, ayant un temps de stabilisation prédéterminé, en série avec un filtre numérique de décimation, le filtre de décimation comportant une pluralité de coefficients de pondération de rang 1 à n, tels que, une première grandeur correspondant au rapport entre la somme des coefficients du filtre de décimation, de rang 1 à m, utilisés pendant le temps de stabilisation du modulateur, et la somme de tous les coefficients du filtre, une seconde grandeur correspondant au rapport entre les amplitudes maximale et minimale des signaux électriques à mesurer, le produit des première et seconde grandeurs est inférieur à ladite précision, m étant très inférieur à n.

La combinaison d'un multiplexeur et d'un convertisseur de type sigma-delta, rendue possible par un choix approprié des coefficients du filtre de décimation, permet de combiner la résolution élevée et l'excellente linéarité du convertisseur sigma-delta, à l'économie de place et de coût liée à l'utilisation d'un multiplexeur et d'un seul convertisseur analogique-numérique.

D'autres avantages et caractéristiques ressortiront plus clairement de la description qui va suivre de modes particuliers de réalisation de l'invention, donnés à titre d'exemples non limitatifs et représentés aux dessins annexés sur lesquels :

La figure 1 représente , sous forme de schéma-bloc, un déclencheur électronique selon l'art antérieur.
La figure 2 illustre un convertisseur analogique-numérique de type sigma-delta selon l'art antérieur.
Les figures 3 et 4 illustrent les variations provoquées lors du passage d'une voie de mesure à la suivante dans un dispositif selon l'invention.
Les figures 5 à 8 représentent sous forme schématique, des variantes des valeurs des coefficients de pondération du filtre de décimation d'un dispositif selon l'invention.

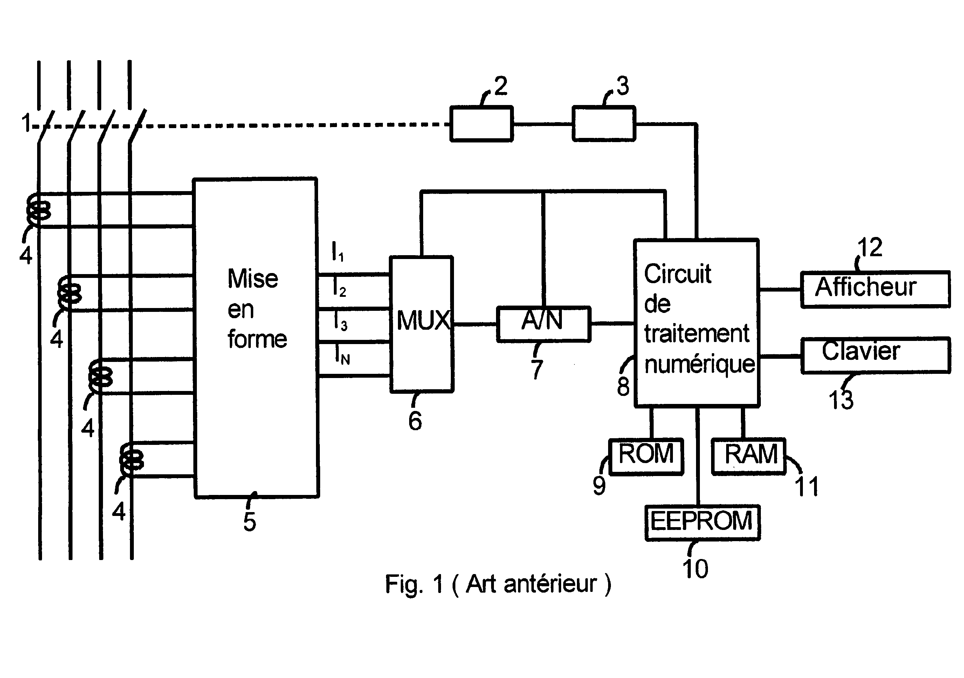

Sur la figure 1, un réseau de distribution électrique d'alimentation d'une charge (non représentée) comporte un disjoncteur 1 susceptible d'interrompre le circuit en position d'ouverture. Le mécanisme 2 du disjoncteur 1 est piloté par un relais polarisé 3 de commande de déclenchement du disjoncteur en cas de surcharge ou de court-circuit. A chaque conducteur est associé un transformateur de courant 4, qui délivre un signal analogique représentatif du courant parcourant le conducteur associé. Ce signal est appliqué à un circuit de mise en forme 5 dont les sorties $I_1$, $I_2$, $I_3$, $I_N$, sont appliquées, par l'intermédiaire d'un multiplexeur 6, à un convertisseur analogique-numérique 7. La sortie du convertisseur est reliée à un circuit de traitement numérique 8, celui-ci contrôlant par ailleurs le multiplexeur et le convertisseur. Le circuit 8 est connecté à divers auxiliaires nécessaires à son fonctionnement, et en particulier à une mémoire morte (ROM) 9, une mémoire vive (RAM) 11, une mémoire non-volatile (EEPROM) 10, un clavier 13 et un afficheur 12. Un dispositif de protection électrique de ce type est classique et décrit, notamment, dans le document US-A-5,101,316.

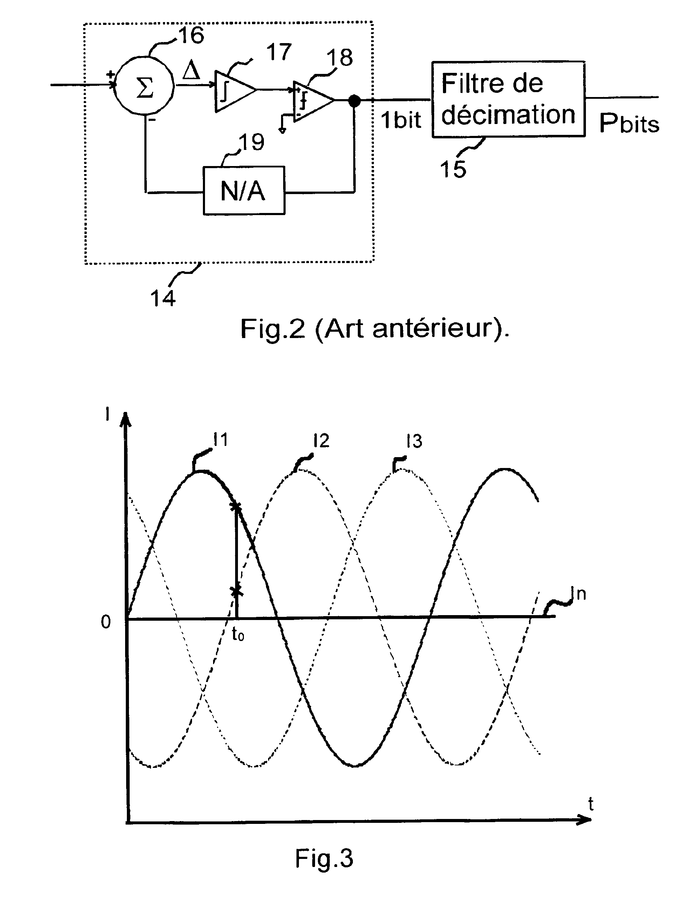

Selon l'invention le convertisseur analogique-numérique 7 est du type sigma-delta. Un tel convertisseur, de type connu, illustré à la figure 2, comporte en série un modulateur sigma-delta 14 et un filtre de décimation 15. Le modulateur sigma-delta 14, convertit les signaux analogiques appliqués à son entrée en un débit ininterrompu de bits, 1 ou 0, à une fréquence prédéterminée, de l'ordre d'1 MHz dans un mode de réalisation préférentiel. Le modulateur 14 comporte, en série, un circuit sommateur différentiel 16, fournissant des signaux Δ, un intégrateur 17 et un comparateur analogique 18. Un convertisseur numérique-analogique 19 à 1 bit, est disposé dans une boucle de contre-réaction, entre la sortie du modulateur 14 et une entrée négative du sommateur différentiel 16. Le filtre de décimation 15 convertit les bits de sortie du modulateur 14 en données codées sur P bits, à une fréquence d'échantillonnage $F_e$. Pour cela, chaque échantillon X de sortie du filtre de décimation est obtenu en faisant la somme de n échantillons successifs $x_i$ de 1 bit, fournis par le modulateur 14, pondérés par un n coefficients de pondération $k_i$ associés du filtre :

$$X = \sum_1^n k_i x_i$$

avec i = 1 à n

Un tel convertisseur présente une résolution élevée, une excellente linéarité et ne nécessite pas d'ajustage. Cependant, si un tel convertisseur est utilisé en aval d'un multiplexeur, les fronts générés par le multiplexeur à chaque changement de voie de mesure sont riches en composantes haute fréquence, ce qui modifie le contenu spectral de chaque signal échantillonné et rend inexploitable son analyse.

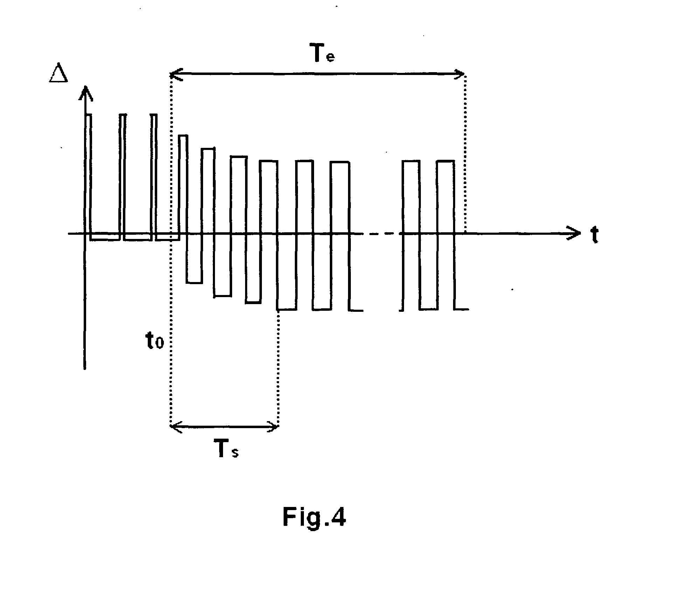

Les figures 3 et 4 illustrent les problèmes posés par le multiplexage de plusieurs voies de mesure dans un dispositif de protection électrique. Sur la figure 3, les courants sinusoïdaux déphasés de 120°, de trois phases $I_1$, $I_2$ (en pointillés fins) et $I_3$ (en gros pointillés) d'un réseau électrique triphasé sont représentés en fonction du temps, ainsi que le courant de neutre $I_N$, normalement nul. Il ressort de la figure 3 qu'à un instant donné $t_0$, si le multiplexeur qui transmettait les signaux $I_1$ au convertisseur analogique-numérique, commute sur la voie de mesure suivante, à savoir la mesure de $I_2$, l'écart d'amplitude peut être important.

Cette variation brusque à l'instant de commutation $t_0$ du multiplexeur provoque l'apparition à l'entrée du filtre de décimation, pendant un temps $T_s$ de stabilisation du modulateur, de signaux transitoires non significatifs. En effet, les signaux $\Delta$ d'entrée de l'intégrateur 17 du modulateur ne se stabilisent qu'après le temps $T_s$ (fig.4). La prise en compte de ces signaux par le filtre de décimation entre les instants $t_0$ et $t_0 + T_s$ fausse la mesure de l'échantillon mesuré entre les instants $t_0$ et $t_0 + T_e$, $T_e$ étant la période d'échantillonnage du filtre de décimation.

A titre d'exemple, dans le cas d'un filtre de décimation fournissant des échantillons codés sur 11 bits (P=11), l'écart maximal entre les amplitudes des signaux à mesurer correspond à un rapport de 4096 (11 bits à 1 vis-à-vis de 1 bit à 1). On peut montrer que, si le 1er échantillon $x_1$ a la valeur la plus élevée correspondant à la valeur du dernier échantillon $x_n$ de la voie de mesure précédente, tous les échantillons suivants de la voie de mesure considérée étant à la valeur 1 représentative de l'échantillon à mesurer, l'erreur générée est de 13% si les coefficients du filtre de décimation forment une courbe du type sinus i/i, avec n = 128. Dans des conditions analogues, si les deux premiers échantillons $x_1$ et $x_2$ sont erronés et égaux à la valeur précédente de $x_n$, l'erreur augmente jusqu'à 50%. Si les coefficients du filtre de décimation forment un triangle, c'est-à-dire si $k_1=k_n=1$, $k_2=k_{n-1}=2$, $k_3=k_{n-3}=3$, l'erreur est encore plus importante, le poids des premiers échantillons $x_1$, $x_2$, étant plus important. On peut dans ce cas atteindre des erreurs de l'ordre de 133% pour un seul bit erroné et de 399 % pour 2 bits erronés.

De manière plus générale, si l'on considère que le dispositif de protection a une dynamique de 200, c'est-à-dire doit pouvoir mesurer des courants allant de 0,1 $I_n$ à 20 $I_n$, $I_n$ étant le courant nominal du dispositif, l'erreur passe de 0,6% pour un bit à 2,4% pour 2 bits et à 72% pour 8 bits erronés dans le cas d'une courbe de sinus i/i. Dans des conditions analogues, avec une répartition en triangle des coefficients de pondération du filtre, l'erreur passe de 6% pour un bit à 19% pour 2 bits et à 232% pour 8 bits erronés.

Les exemples ci-dessus montrent clairement le problème posé par le multiplexage de signaux en amont d'un convertisseur analogique-numérique de type sigma-delta.

Soit une première grandeur $G_1$ égale au rapport entre la somme $\sum_1^m k_i$ des coefficients du filtre de décimation, de rang 1 à m, utilisés pendant le temps $T_s$ de stabilisation du modulateur et la somme $\sum_1^n k_i$ de tous les coefficients du filtre. Soit une seconde grandeur $G_2$ égale au rapport entre les amplitudes maximale et minimale des signaux électriques à mesurer, c'est-à-dire représentative de la dynamique de mesure.

Selon l'invention, les coefficients $k_1$ de pondération du filtre doivent être tels que le produit $G_1.G_2$ soit inférieur à la précision souhaitée par la mesure des signaux électriques.

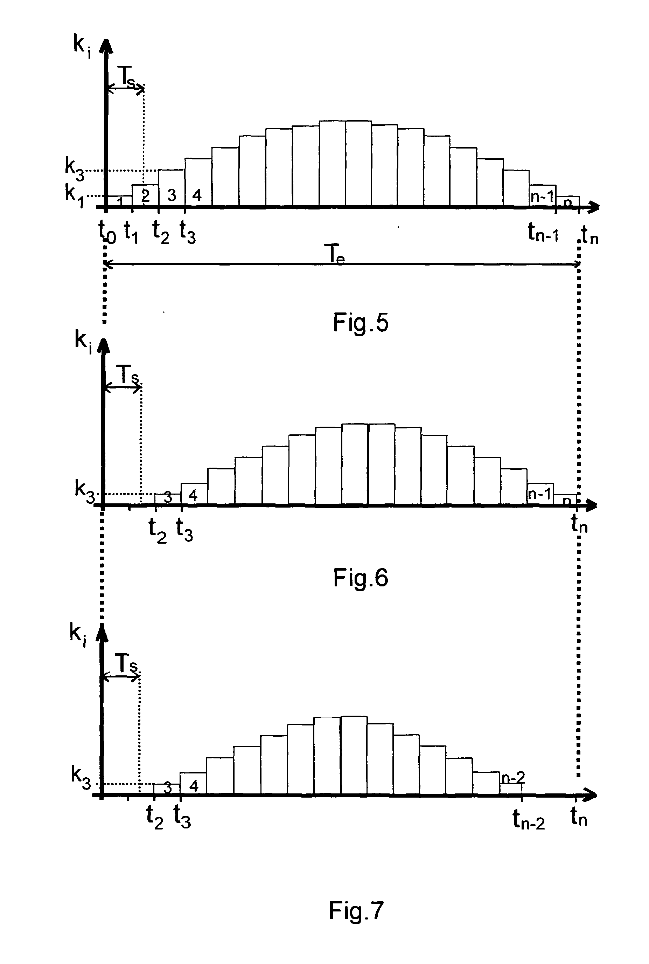

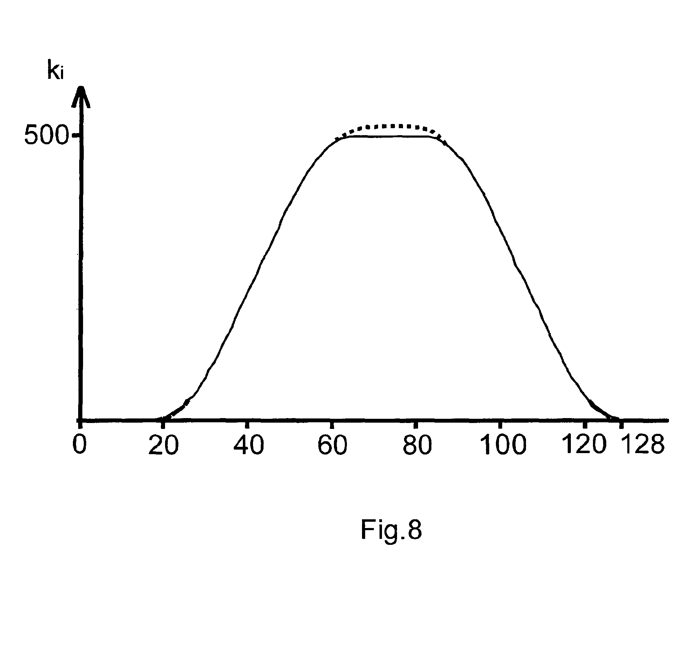

Sur les figures 5 à 7, le temps de stabilisation $T_s$ du modulateur est inférieur à la durée ($t_0 - t_2$) de 2 bits de sortie du modulateur sigma-delta. Dans ce cas m = 2. Il suffit donc que les coefficients $k_1$ et $k_2$, de rang 1 à m, soient choisis de manière à ce que la condition : $G_1.G_2$ < précision soit remplie. Le nombre n de coefficients représentés sur les figures 5 à 7 a été limité pour des raisons de clarté. Dans un mode de réalisation préférentiel, représenté à la figure 8, n = 128 et m=8. Le nombre m est toujours très inférieur à n, le temps de stabilisation $T_s$ du modulateur étant très inférieur à $T_e$.

Les coefficients du filtre forment, de préférence, une courbe en sinus i/i, comme représenté sur les figures 5 à 7 et sur la figure 8 en pointillé. Dans un mode de réalisation préférentiel, représenté à la figure 8, cette courbe est modifiée dans sa partie centrale, les coefficients du filtre étant limités à une valeur prédéterminée, 511 sur la figure. Ceci permet de limiter la taille d'une mémoire, par exemple de type ROM, contenant les coefficients à une ROM à 9 bits.

De manière classique, les coefficients de pondération du filtre de décimation sont, de préférence, symétriques : $k_1 = k_n$, $k_2 = k_{n-1}$, $k_3 = k_{n-3}$... (figures 5 et 7), ce qui permet une meilleure réjection du bruit.

Les figures 6 et 7 diffèrent de la figure 5 par le fait que les deux premiers coefficients, $k_1$ et $k_2$, utilisés pendant le temps $T_s$ de stabilisation du modulateur, sont nuls. Dans les deux cas, la grandeur $G_1$ est alors nulle, et le produit $G_1.G_2$ nul, remplissant ainsi automatiquement la condition " $G_1.G_2$ inférieur à la précision ". Sur la figure 7, les coefficients du filtre sont symétriques, tandis que sur la figure 6, seuls les coefficients non nuls sont symétriques. Ainsi, sur la figure 6 : $k_3 = k_n$ $k_4 = k_{n-1}$, ..., tandis que sur la figure 7 : $k_3 = k_{n-2}$, $k_4 = k_{n-3}$,...

Dans un mode de réalisation préférentiel, le multiplexeur est un multiplexeur à 4 voies, la fréquence de sortie du modulateur sigma-delta est de 1MHz, le filtre comporte 128 coefficients (n=128), formant une courbe en sinus i/i, limités à la valeur 511, les 18 premiers coefficients $k_1$ à $k_{18}$ étant nuls et les coefficients non nuls du filtre étant symétriques (fig.8).

Pour une fréquence de sortie du modulateur de 1MHz, si le temps $T_s$ de stabilisation du modulateur est de l'ordre de 8µs, m=8, la mise à zéro des 8 premiers coefficients du filtre permet dans tous les cas de remplir la condition précitée.

La pondération des m premiers bits d'un échantillon par le coefficient zéro permet ainsi l'élimination de l'erreur due au multiplexage.

L'invention permet de réduire le nombre de convertisseurs utilisés, ce qui réduit le coût de l'électronique. Elle permet également de gagner de la place si la fonction de conversion est intégrée dans un ASIC, ainsi que de diminuer le courant consommé par les circuits électroniques. Cette dernière caractéristique permet en conséquence d'alléger la charge des éléments assurant l'alimentation des circuits électroniques et/ou d'en diminuer la taille ou la tenue thermique.

Dans le cas d'un déclencheur électronique, les capteurs sont des capteurs de courant. Un déclencheur haut de gamme, effectuant également des mesures de tension et, éventuellement, de puissance, peut également comporter des capteurs de tension. Dans un mode de réalisation particulier, un tel déclencheur comporte deux multiplexeurs, à 4 voies chacun, l'un deux étant associé aux capteurs de courant ($I_1$, $I_2$, $I_3$, $I_N$) et l'autre aux capteurs de tension ($U_1$, $U_2$, $U_3$) et à un capteur de courant homopolaire ($I_G$). Chaque multiplexeur est connecté en série à un convertisseur analogique-numérique de type sigma-delta, à 15 bits, intégrés dans un ASIC. Le filtre de décimation peut être inclus dans le circuit de traitement numérique, également intégré dans l'ASIC. L'utilisation de deux convertisseurs permet l'acquisition et la conversion simultanée des courants et des tensions, ce qui élimine les erreurs dues au déphasage tension-courant pour le calcul de la puissance.

L'invention n'est pas limitée aux modes particuliers de réalisation représentés sur les figures et décrits ci-dessus. Elle s'applique à tout dispositif de protection électrique comportant au moins deux voies de mesure multiplexées utilisant un même convertisseur analogique-numérique de type sigma-delta.

**Revendications**

1. Dispositif de protection pour un réseau électrique comportant une pluralité de capteurs (4), un multiplexeur (6), connecté à la sortie des capteurs pour recevoir une pluralité de signaux électriques à mesurer avec une précision prédéterminée, un convertisseur analogique-numérique (7), connecté à la sortie du multiplexeur, et des moyens de traitement numérique (8) connectés au convertisseur analogique-numérique, dispositif **caractérisé en ce que** le convertisseur analogique-numérique (7) est du type sigma-delta, comportant un modulateur sigma-delta (14), ayant un temps de stabilisation ($T_s$) prédéterminé, en série avec un filtre numérique de décimation (15), le filtre de décimation (15) comportant une pluralité (n) de coefficients de pondération ($k_i$) de rang 1 à n, tels que, une première grandeur ($G_1$) correspondant au rapport entre la somme des coefficients du filtre de décimation, de rang 1 à m, utilisés pendant le temps de stabilisation du modulateur, et la somme de tous les coefficients du filtre, une seconde grandeur ($G_2$) correspondant au rapport entre les amplitudes maximale et minimale des signaux électriques à mesurer, le produit des première et seconde grandeurs est inférieur à ladite précision, m étant très inférieur à n..

2. Dispositif selon la revendication 1, **caractérisé en ce que** les coefficients du filtre de rang 1 à m sont nuls.

3. Dispositif selon la revendication 2, **caractérisé en ce que** les coefficients non nuls du filtre sont symétriques.

4. Dispositif selon l'une des revendications 1 et 2, **caractérisé en ce que** les coefficients du filtre sont symétriques.

5. Dispositif selon l'une quelconque des revendications précédentes, **caractérisé en ce que** les coefficients du filtre forment une courbe du type (sinus i)i.

6. Dispositif selon la revendication 5, **caractérisé en ce que** les coefficients du filtre sont limités à une valeur prédéterminée.

**7.** Dispositif selon l'une quelconque des revendications précédentes, **caractérisé en ce que** les capteurs (4) sont des capteurs de courant, le dispositif étant un déclencheur.

**8.** Dispositif selon l'une quelconque des revendications précédentes, **caractérisé en ce que** les moyens de traitement numérique comportent le filtre de décimation.

## Claims

**1.** An electrical protection device for a power system comprising a plurality of sensors (4), a multiplexer (6) connected to the output of the sensors to receive a plurality of electrical signals to be measured with a predetermined precision, an analog-to-digital converter (7) connected to the multiplexer output, and digital processing means (8) connected to the analog-to-digital converter, a device **characterized in that** the analog-to-digital converter (7) is of the sigma-delta type comprising a sigma-delta modulator (14), having a preset stabilization time ($T_s$), connected in series with a digital decimation filter (15), the decimation filter comprising a plurality (n) of weighting coefficients ($k_i$) of rank 1 to n, such that, a first quantity ($G_1$) corresponding to the ratio between the sum of the coefficients of the decimation filter of rank 1 to m used during the modulator stabilization time, and the sum of all the coefficients of the filter, a second quantity ($G_2$) corresponding to the ratio between the maximum and minimum amplitudes of the electrical signals to be measured, the product of the first and second quantities is lower than said precision, m being much lower than n.

**2.** The device according to claim 1, **characterized in that** the coefficients of the filter of rank 1 to m are zero.

**3.** The device according to claim 2, **characterized in that** the non-zero coefficients of the filter are symmetrical.

**4.** The device according to one of claims 1 and 2, **characterized in that** the coefficients of the filter are symmetrical.

**5.** The device according to any one of the foregoing claims, **characterized in that** the coefficients of the filter form a (sine i)/i type curve.

**6.** The device according to claim 5, **characterized in that** the coefficients of the filter are limited to a preset value.

**7.** The device according to any one of the foregoing claims, **characterized in that** the sensors (4) are current sensors, the device being a trip device.

**8.** The device according to any one of the foregoing claims, **characterized in that** the digital processing means comprise the decimation filter.

## Patentansprüche

**1.** Schutzeinrichtung für ein elektrisches Leitungsnetz mit mehreren Messwandlern (4), einem an die Ausgänge der Messwandler angeschlossenen Multiplexer (6) zur Aufnahme mehrerer, mit einer bestimmten Genauigkeit zu messenden elektrischen Signale, einem an den Ausgang des Multiplexers angeschlossenen Analog-Digital-Umsetzer (7) sowie an den Analog-Digital-Umsetzer angeschlossenen digitalen Verarbeitungsmitteln (8), welche Einrichtung **dadurch gekennzeichnet ist, dass** der Analog-Digital-Umsetzer (7) als Sigma-Delta-Wandler ausgebildet ist und einen Sigma-Delta-Modulator (14) mit einer bestimmten Einschwingzeit (T) umfasst, der in Reihe zu einem digitalen Dezimationsfilter (15) geschaltet ist, welches Dezimationsfilter (15) mehrere (n) Gewichtungskoeffizienten ($k_i$) der Ordnung 1 bis n umfasst, derart dass eine erste Größe (G1) dem Verhältnis zwischen der Summe der während der Einschwingzeit des Modulators verwendeten Gewichtungskoeffizienten der Ordnung 1 bis m des Dezimationsfilters und der Summe aller Gewichtungskoeffizienten des Filters entspricht, eine zweite Größe (G2) dem Verhältnis zwischen den größten und den kleinsten Amplituden der zu messenden elektrischen Signale entspricht und das Produkt aus der ersten und der zweiten Größe kleiner als die genannte Genauigkeit ist, wobei m wesentlich kleiner als n ist.

**2.** Einrichtung nach Anspruch 1, **dadurch gekennzeichnet, dass** die Gewichtungskoeffizienten der Ordnung 1 bis m des Filters null sind.

**3.** Einrichtung nach Anspruch 2, **dadurch gekennzeichnet, dass** die Gewichtungskoeffizienten des Filters, deren Wert ungleich null ist, symmetrisch sind.

**4.** Einrichtung nach einem der Ansprüche 1 und 2, **dadurch gekennzeichnet, dass** die Gewichtungskoeffizienten des Filters symmetrisch sind.

**5.** Einrichtung nach irgendeinem der vorhergehenden Ansprüche, **dadurch gekennzeichnet, dass** die Gewichtungskoeffizienten des Filters eine Kurve vom Typ (sinus i)/i ergeben.

**6.** Einrichtung nach Anspruch 5, **dadurch gekenn-**

**zeichnet, dass** die Gewichtungskoeffizienten des Filters auf einen bestimmten Wert begrenzt sind.

7. Einrichtung nach irgendeinem der vorhergehenden Ansprüche, **dadurch gekennzeichnet, dass** die Messwandler (4) als Stromwandler ausgebildet sind und die Einrichtung einen Auslöser darstellt.

8. Einrichtung nach irgendeinem der vorhergehenden Ansprüche, **dadurch gekennzeichnet, dass** die digitalen Verarbeitungsmittel das Dezimationsfilter umfassen.

Fig. 1 ( Art antérieur )

Fig.2 (Art antérieur).

Fig.3

**Fig.4**

Fig.5

Fig.6

Fig.7

Fig.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5101316 A
- US 4672501 A

- US 4943888 A